# EUROPEAN PATENT APPLICATION

(11) **EP 3 188 193 A1**
(43) Date of publication of application: **05.07.2017**
(21) Application number: 14900613.2
(22) Date of filing: 29.08.2014
(51) Int. Cl.: G21C 17/10, G21C 17/108, H03G 3/30

(54) **EXCORE NUCLEAR INSTRUMENTATION DEVICE**

(71) Applicant: Mitsubishi Electric Corporation, Chiyoda-ku Tokyo 100-8310 (JP)
(72) Inventor: TSUDA Hiroyuki, Tokyo 100-8310 (JP); SAITO Atsushi, Tokyo 100-8310 (JP)
(74) Representative: Sajda, Wolf E.
(86) International application number: PCT/JP2014/072723
(87) International publication number: WO 2016/031045

(57) **Abstract**

A detector signal processing circuit comprises a current/voltage converting unit (21) which converts the current value, which is converted by a neutron detector (3), to a voltage value which corresponds to the current value; a variable gain amplifying unit (22) which includes an operating amplifier, in which a D/A converter is added, and amplifies the voltage value which is converted by the current/voltage converting unit (21); a regulation control means (26 to 28) which regulates a gain of the D/A converter; and a comparator (29) which automatically compares an output voltage, which is amplified by the variable gain amplifying unit (22), in accordance with a reference value which is previously set, so as to output the output voltage to the regulation control means (26 to 28).

## Description

### BACKGROUND OF THE INVENTION

### Technical Field

The present invention relates to an ex-core nuclear instrumentation device which monitors a neutron beam at the outside of a nuclear reactor vessel, and particularly relates to a labor saving of calibration work of a neutron detector in accordance with an improvement of a detector signal processing circuit (I/E amplifier) which is installed in an ex-core nuclear instrumentation board which composes the ex-core nuclear instrumentation device.

### Background Art

An ex-core nuclear instrumentation device continuously monitors a neutron beam at the outside of a nuclear reactor vessel of a Pressurized Water Reactor (PWR), whereby the ex-core nuclear instrumentation device monitors a state of a nuclear reactor when the nuclear reactor is started and operated, and when an abnormality is detected in a state of the neutron beam, an alarm signal or an emergency stop signal of the nuclear reactor is output, whereby the nuclear reactor is protected.

The ex-core nuclear instrumentation device is mainly composed of a neutron detector which measures the neutron beam so as to convert the neutron beam to a current value, and an ex-core nuclear instrumentation board which computes and processes the converted current value so as to convert the current value to the above-described signals.

In general, a neutron measurement region of an ex-core nuclear instrumentation device is separated to a neutron source region, a middle region, and an output region (operation region) in accordance with a level of a neutron beam from a stop state to an output operation state of a nuclear reactor.

Configurations and functions of a neutron detector and an ex-core nuclear instrumentation board are different in each of the regions, and a detector signal processing circuit (I/E amplifier, in other words, current/voltage amplifier) is used for a computing process in the output region.

A conventional technology suggests already an ex-core nuclear instrumentation device in which the detector signal processing circuit is composed of a current/voltage converting unit which converts a current value converted by a neutron detector, to a voltage value corresponding to the current value, and a variable gain amplifying unit which amplifies the voltage value converted by the current/voltage converting unit, and the variable gain amplifying unit is composed of a current-level-responsible resistor circuit, which can select a gain, and a D/A converter, which regulates the gain, whereby even when a neutron detection current is minute, a voltage level, which corresponds to a reactor output level, can be output, and a correct measurement value of a neutron beam is obtained (refer to Patent Document 1).

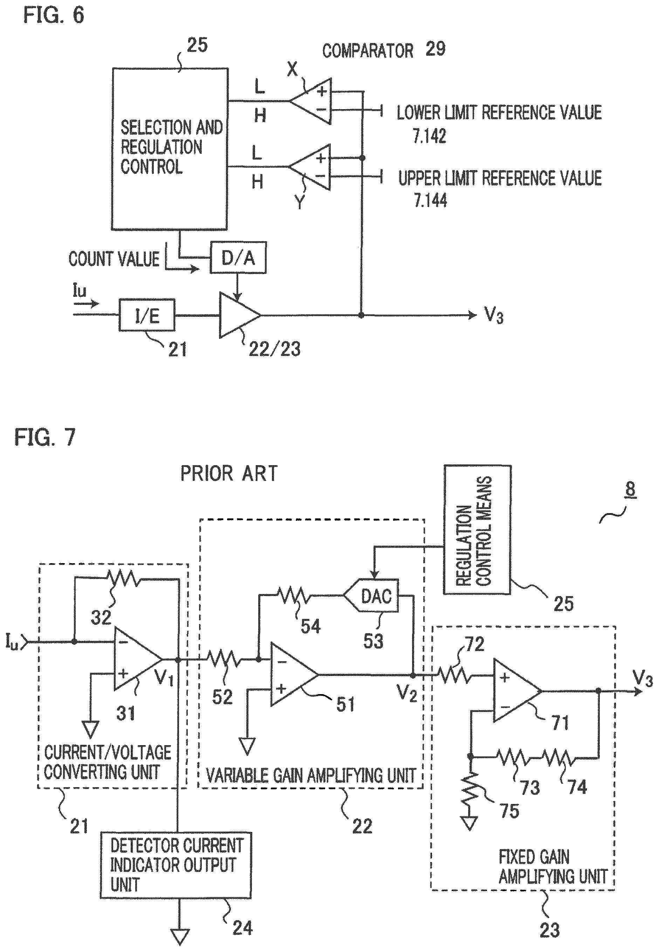

A calibration function of the detector signal processing circuit of the conventional neutron detector, which is suggested above, will be explained in reference to FIG. 7. Firstly, a detector current is converted to a voltage by a current/voltage converting unit 21, and the voltage is input to a variable gain amplifying unit 22.

A gain of the current/voltage converting unit 21 and a gain of a fixed gain amplifying unit 23, which is described later, are constant. Secondly, the detector current is measured by a detector current indicator output unit 24, and an output signal V1 is input to an inverting amplifier 51 of the variable gain amplifying unit 22.

In the variable gain amplifying unit 22, a D/A converter 53 is regulated by a regulation control means 25 in order to previously calibrate an output to a voltage value corresponding to a reactor output, whereby an output signal V3 of a detector signal processing circuit 8 is determined. Moreover, an output signal V2 of the variable gain amplifying unit 22 is amplified by an inverting amplifier 71 of the fixed gain amplifying unit 23, and the output signal V3 is input to a signal processing card which is described later.

In this case, the output signal V3 is a voltage value which corresponds to a reactor output, and a constant level, which corresponds to the reactor output, is required in a computing process after a computing process of the signal processing card, so that the detector current is converted to a voltage by the current/voltage converting unit 21, and moreover, the voltage value is amplified by the variable gain amplifying unit 22.

### Prior Art Document

### Patent Document

- Patent Document 1:: Japanese Laid-Open Patent Application Publication JP 2012-163 362 A

### SUMMARY OF THE INVENTION

### Problems to be Solved by the Invention

However, in a calibration device of a conventional neutron detector which has been suggested as indicated above, an output voltage is manually and sequentially regulated so as to be reached to a target value, based on a current value which is commanded by a detector current indicator output unit, by a selection regulation control means which regulates a gain of a D/A converter.

Therefore, it is required that a worker sequentially regulates an output voltage, by using an increase or decrease button which is provided on an operation panel, in order to bring the output voltage to the target value while the worker checks the current value which is commanded by the detector current indicator output unit, and instruments, such as a voltmeter and an indicator, must be constantly monitored, so that a manpower and a working time therefor are required.

Moreover, there is a case in which the regulation is performed when a nuclear reactor is operated, so that a load of an operator is increased for the regulation including a nighttime regulation or the like, and there is a possibility in which a regulation of an input current is mistaken by any operator.

The present invention has been made to solve above-described problems, and an object of the invention is to provide an ex-core nuclear instrumentation device in which it is not required that a worker sequentially regulates an output voltage by a manual button in order to constantly bring the output voltage to a target value, and a calibration work of a neutron beam level signal output is automatically performed with respect to a neutron detector signal input, whereby a labor saving and high accuracy of calibration work are encouraged.

### Means for Solving Problems

An ex-core nuclear instrumentation device of the present invention comprises:
- a neutron detector which is adapted to measure a neutron beam at the outside of a nuclear reactor vessel and to convert the neutron beam to a current value; and
- an ex-core nuclear instrumentation board which is adapted to compute and processes the current value from the neutron detector by using a detector signal processing circuit so as to output a state of the neutron beam when a nuclear reactor is operated;
wherein the detector signal processing circuit comprises
- a current/voltage converting unit which is adapted to convert the current value converted by the neutron detector, to a voltage value corresponding to the current value;
- a variable gain amplifying unit which includes an operating amplifier, in which a D/A converter is added, and is adapted to amplify the voltage value converted by the current/voltage converting unit;
- a regulation controller which is adapted to regulate a gain of the D/A converter; and
- a comparator which is adapted to compare an output voltage amplified by the variable gain amplifying unit with a reference value previously set, and to output its output to the regulation controller.

### Effects of the Invention

According to an ex-core nuclear instrumentation device of the present invention, a load of a worker can be particularly reduced when nighttime work is performed, and a human error is prevented, and the ex-core nuclear instrumentation device has an effect in which a labor saving of calibration work of a neutron beam signal output, which corresponds to a neutron detector signal input having high reliability, can be realized.

### BRIEF DESCRIPTION OF THE DRAWINGS

- FIG. 1: is a configuration diagram illustrating a general configuration of an ex-core nuclear instrumentation device in an output region;
- FIG. 2: is a basic circuit configuration diagram illustrating a detector signal processing circuit of the present invention;
- FIG. 3: is a circuit configuration diagram illustrating a detector signal processing circuit according to Embodiment 1 of the present invention;
- FIG. 4: is a circuit configuration diagram illustrating a detector signal processing circuit according to Embodiment 2;
- FIG. 5: is a circuit configuration diagram illustrating a detector signal processing circuit according to Embodiment 3;
- FIG. 6: is a circuit diagram illustrating a specific configuration example of a comparator according to the above-described Embodiment 1 through Embodiment 3; and
- FIG. 7: is a basic circuit configuration diagram illustrating a conventional detector signal processing circuit.

### MODE FOR CARRYING OUT THE INVENTION

### Embodiment 1

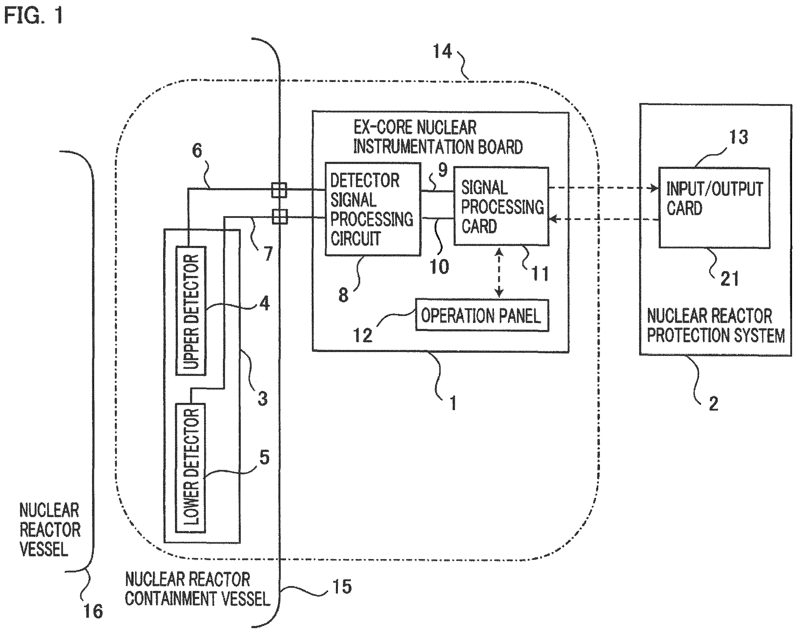

FIG. 1 is a configuration diagram illustrating a general configuration of an ex-core nuclear instrumentation device in an output region. In FIG. 1, a neutron detector 3 of an ex-core nuclear instrumentation device 14 is provided at an adjacent position of the outside of a nuclear reactor vessel 16 which is installed in a nuclear reactor containment vessel 15.

The neutron detector 3 is configured by integrating an upper detector 4, which detects a neutron, which is leaked from an upper portion of the nuclear reactor vessel 16, so as to convert the neutron to a current value, and a lower detector 5, which detects a neutron, which is leaked from a lower portion of the nuclear reactor vessel 16, so as to convert the neutron to a current value.

The current value, which is converted by the upper detector 4, is input to a detector signal processing circuit 8 in an ex-core nuclear instrumentation board 1 of the ex-core nuclear instrumentation device 14, which is generally disposed at the outside of the nuclear reactor containment vessel 15, via an upper detector cable 6. The current value, which is converted by the lower detector 5, is similarly input to the detector signal processing circuit 8 via a lower detector cable 7.

The detector signal processing circuit 8 includes a circuit, which corresponds to the upper detector 4, and a circuit, which corresponds to the lower detector 5, and a current value is converted to an upper detector output voltage 9 and a lower detector output voltage 10 by the detector signal processing circuit 8. Both the output voltage 9 and the output voltage 10 are input to a signal processing card 11 in the ex-core nuclear instrumentation board 1.

In the signal processing card 11, an A/D (analog/digital) conversion and an engineering value conversion are performed, and various signals are output to an operation panel 12 and an input/output card 13 in a nuclear reactor protection system 2.

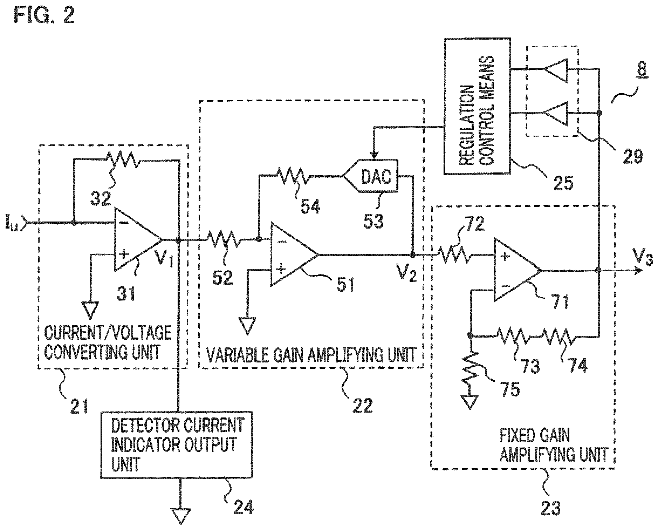

FIG. 2 is a basic circuit configuration diagram illustrating the detector signal processing circuit 8 of the neutron detector 3. The detector signal processing circuit 8 comprises: a current/voltage converting unit 21 which converts a current value Iu, which is converted from a neutron beam which is detected by the upper detector 4 or the lower detector 5, to a voltage value V1; a variable gain amplifying unit 22 which amplifies the voltage value V1 at a first stage and sets to a voltage value 2; a fixed gain amplifying unit 23 which amplifies the voltage value V2, which is once amplified, at a second stage and outputs the amplified voltage value as a voltage value V3 from the detector signal processing circuit 8; a detector current indicator output unit 24 which displays the voltage value V1 which is converted by the current/voltage converting unit 21; a regulation control means 25 which regulates an amplifying width of the variable gain amplifying unit 22; and a comparator 29 which compares a voltage value, which is obtained by the variable gain amplifying unit 22, with a reference value which is predefined.

In addition, although the fixed gain amplifying unit 23 is disposed at a rear stage of the variable gain amplifying unit 22 in the above-described explanation, it is possible that the variable gain amplifying unit 22 is disposed at a rear stage of the fixed gain amplifying unit 23.

Firstly, according to a function of the detector signal processing circuit 8, a current Iu, which is measured by the neutron detector 3, is input to an inverting amplifier 31, in which an operating amplifier is used, by the current/voltage converting unit 21, and the voltage value V1, which corresponds to the current Iu, is output. An input impedance of the computing amplifier is very high, so that a current is not flowed to the inverting amplifier 31, and all currents are flowed to a resistor 32.

An output voltage of the inverting amplifier 31 is "- (resistor value 32 x detector current)". Secondly, a gain is regulated by the variable gain amplifying unit 22, whereby an output voltage can be set as 0 V through 2 V. Moreover, the fixed gain amplifying unit 23 composes a non-inverting amplifier, and a gain is "(1 + R73/75)", and an output is roughly 5 times (0 V through 10 V).

In FIG. 2, a gain of the current/voltage converting unit 21 and a gain, which is described later, of the fixed gain amplifying unit 23 are constant. The detector current indicator output unit 24, which displays a detector current in accordance with the voltage value 1, is connected to an output side of the current/voltage converting unit 21, and moreover, the voltage value 1 is input to an inverting amplifier 51 which is an operating amplifier of the variable gain amplifying unit 22.

In the variable gain amplifying unit 22, the D/A converter 53 is regulated by the regulation control means 25, by which the output voltage V3 is previously calibrated to a voltage value corresponding to a reactor output, and the comparator 29 which is connected to an input stage of the regulation control means 25, whereby the output voltage V3 of the detector signal processing circuit 8 is determined.

In other words, an amplifying width of the variable gain amplifying unit 22 is regulated by the comparator 29 which is connected to the regulation control means 25. In addition, this regulation is performed after the neutron detector 3 (refer to FIG. 1) is installed, and detection accuracy, which is caused in accordance with a reactor output, a leak amount of a neutron from nuclear reactor vessel 16, an error of an installed detector, and an installation location of the neutron detector 3, is absorbed.

A D/A converter 53 is an electronic circuit (for example, 12 bits circuit) which converts a digital electric signal, which is output from the regulation control means 25, to an analog electric signal (a resistance value), and the D/A converter 53 can convert the digital electric signal to a small resistance value (roughly 1/10000). Moreover, the voltage value V2, which is output from the variable gain amplifying unit 22, is amplified by a non-inverting amplifier 71 which is an operating amplifier of the fixed gain amplifying unit 23, and the output voltage V3, which is an output signal, is input to the signal processing card 11 (refer to FIG. 1).

In this case, the output voltage V3, which is the output signal, is a voltage value which corresponds to a reactor output (for example, a voltage value 3.3 V which corresponds to a reactor output 100 %), and a voltage value at a certain level, which corresponds to a reactor output, is required for a computing process after a computing process of the signal processing card 11, so that the detector current Iu is converted to a voltage value by the detector signal processing circuit 8 so as to be amplified. In addition, a symbol 54 is a fixed resistor, and a symbol 52 and symbols 72 through 75 are resistors.

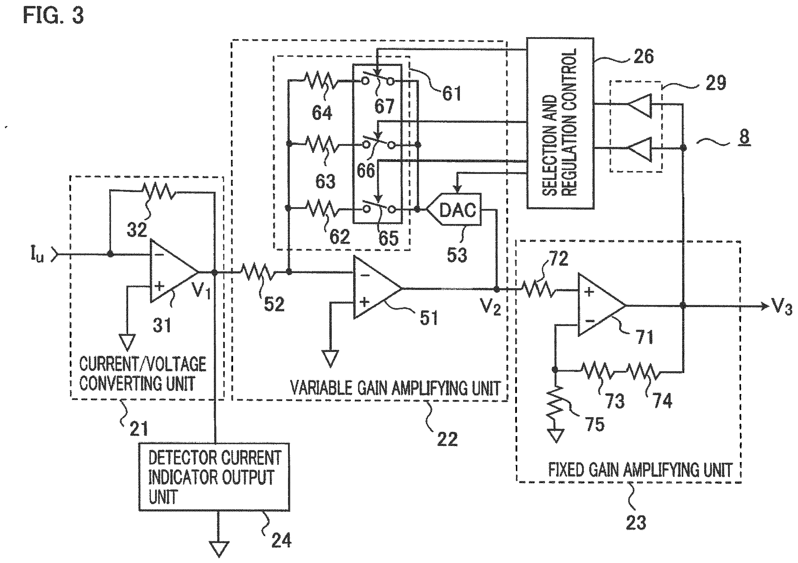

FIG. 3 is a circuit configuration diagram illustrating a detector signal processing circuit (I/E amplifier) according to Embodiment 1 of the present invention. Components, which are different from components of the detector signal processing circuit 8 in FIG. 1, will be mainly explained.

In addition, reference symbols, which are the same as those in each of the drawings, refer to the same or equivalent parts. In the circuit configuration in FIG. 3, the fixed resistor 54 (refer to FIG. 2) of the variable gain amplifying unit 22 is composed of a current-level-responsible resistor circuit 61 by which a gain can be selected.

The current-level-responsible resistor circuit 61 is composed of a parallel component in which a plurality of serial components, in which a resistor and an analog switch are connected in series, are connected in parallel. Symbols 62 through 65 are resistors, and symbols 65 through 67 are analog switches. Thereby, the analog switches are selectively closed, and the current-level-responsible resistor circuit 61 can be configured as a high resistance circuit which is capable for a low current level. In addition, the current-level-responsible resistor circuit 61 can be configured by using a variable resistor.

A resistor of the current-level-responsible resistor circuit 61 is selected, whereby a gain of the inverting amplifier 51 can be selected. The resistors are set as the resistor 62 = R1, ..., the resistor 63 = R2, and the resistor 64 = R3, and a resistance value is varied in stages with one-digit unit as R1, ..., R2, R3 = 1 / 100R, ..., 10R, and 100R, whereby the current-level-responsible resistor circuit 61 is controlled in such a way that a required resistor is selected in accordance with a turned-on or turned-off operation of an analog switch by the comparator 29, by which a voltage value, which is obtained by the variable gain amplifying unit 22, is compared based on a preset value, and the selection regulation control means 26.

Thereby, a width of a gain of the variable gain amplifying unit 22 can be extended in comparison with a fixed resistance value. In addition, when the current Iu, which is measured by the neutron detector 3, is small, a large resistance value is selected.

A gain of the variable gain amplifying unit 22 can be varied by regulating a resistance value of the D/A converter 53 by a digital electric signal in accordance with an instruction output from the comparator 29 which is connected to the selection regulation control means 26. However, in a case where the current-level-responsible resistor circuit 61 is used as a fixed resistor and a resistance value is regulated only by the D/A converter 53, when a lower limit of a current input range is decreased, for example, to 1 µA, a voltage variation width with respect to a count value for setting a gain (digital electric signal) in the D/A converter 53 is increased, whereby the accuracy is decreased.

Therefore, in FIG. 3, the current-level-responsible resistor circuit 61, by which a gain can be selected, and the D/A converter 53, by which a gain is regulated, are connected as two-stage series configuration, and a gain is largely selected by the current-level-responsible resistor circuit 61, and the gain is minutely regulated by the D/A converter 53, whereby a gain having high accuracy can be automatically regulated.

Hereinafter, a selection of the current-level-responsible resistor circuit 61 and a regulation of the D/A converter 53 by a selection regulation control means 26 of the variable gain amplifying unit 22 according to Embodiment 1, and a function of the comparator 29 will be explained.

When the neutron detector current Iu, which corresponds to a reactor output 100 % level, is input to the current/voltage converting unit 21, the current Iu is converted to the voltage value V1 by the inverting amplifier 31 so as be output. Next, a detector current is displayed by the detector current indicator output unit 24, and the voltage value V1 is input to the inverting amplifier 51 of the variable gain amplifying unit 22.

In this case, a resistance value of the current-level-responsible resistor circuit 61 of the inverting amplifier 51 of the variable gain amplifying unit 22 is selectively switched in accordance with a current level (a detector current which is displayed by the detector current indicator output unit 24), and a resistance value of the D/A converter 53 is regulated, and a gain of the variable gain amplifying unit 22 is varied, whereby the output voltage V3 of the detector signal processing circuit 8 can be agreed with a required current level (for example, V3 = 3.3 V).

The comparator 29 compares an upper limit voltage reference value and a lower limit voltage reference value, which are previously set, in the comparator 29, and the comparator 29 automatically regulates a resistance value of the D/A converter 53 via the selection regulation control means 26 in such a way that the voltage reference values are set within voltage values at constant levels which are required for a computing process after a computing process of the signal processing card 11.

FIG. 6 is an example of a specific circuit which is configured by combining two-stage comparators X and Y, and when a target value is, for example, 7.143 V, a lower limit reference value 7.142 V is previously set to an inverting input (-) of the comparator X, and an upper limit reference value 7.144 V is previously set to an inverting input (-) of the comparator Y, and the voltage value V3 is input to a non-inverting input (+) of the both comparators, whereby the comparators are automatically regulated in such a way that the target value (7.143 V) is realized and is set within a span between the upper limit value and the lower limit value.

In a specific operation, an automatic button, which is provided at a panel surface of an operation unit, of a selection and regulation control unit is pressed down, whereby the count value, which is automatically regulated, is transmitted to the D/A converter 53, and a gain can be automatically regulated.

Therefore, the detector current indicator output unit 24 only displays a detector current, and it is not required that a worker verifies the detector current indicator output unit 24 point by point as in a conventional operation.

In other words, when a measured current is minute and the output voltage V3 of the detector signal processing circuit 8 is not reached to a required voltage level, the analog switches 65 through 67 are turned on or turned off, and the resistors 62 through 64 of the current-level-responsible resistor circuit 61 are selected, whereby a resistance value is switched, and moreover, a resistance value of the D/A converter 53 is regulated, and a gain of the variable gain amplifying unit 22 is varied, and the output voltage V3 of the detector signal processing circuit 8 can be agreed with a required voltage level.

Moreover, the D/A converter 53 is regulated, whereby resistance values, in which a resistance value of the D/A converter 53, a resistance value which is selected by the current-level-responsible resistor circuit 61, and a turned-on resistance value of an analog switch are includes, can be minutely regulated.

Therefore, a width of a gain, which is included in the variable gain amplifying unit 22, can be automatically varied, by the comparator 29 which is connected to the selection regulation control means 26, with a larger and higher accuracy width in comparison with a conventional device. Therefore, as a result, a width of a current of the neutron detector 3, which can be measured, can be extended.

### Embodiment 2

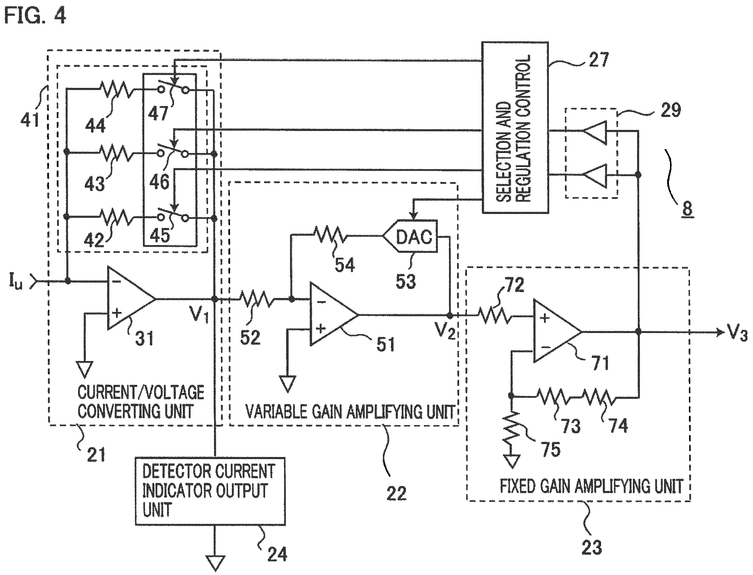

FIG. 4 is a circuit configuration diagram illustrating a detector signal processing circuit (I/E amplifier) 8 according to Embodiment 2. In Embodiment 1, a case, in which a switching control is performed by adding the current-level-responsible resistor circuit 61, which is composed of a resistor and an analog switch, to the variable gain amplifying unit 22, is described, whereas in Embodiment 2, as indicated in FIG. 4, a current-level-responsible resistor circuit 41, which is composed of a resistor and an analog switch, to a current/voltage converting unit 21 with respect to a basic circuit configuration indicated in FIG. 1.

In addition, symbols 42 through 44 designate resistors, and symbols 45 through 47 designate analog switches. Moreover, a resistance value of the current-level-responsible resistor circuit 41 is automatically switched by a comparator 29 which is connected to a selection regulation control means 27.

In other words, when a measured current is minute and an output voltage V3 of a detector signal processing circuit 8 is not reached to a required voltage level, a turned-on or turned-off operation of the analog switches 45 through 47 is automatically controlled by the comparator 29, which is connected to the selection regulation control means 27, and a resistance value is selected, and a gain of the current/voltage converting unit 21 is varied, and moreover, a resistance value of a D/A converter 53, which is provided in a variable gain amplifying unit 22, is minutely regulated by the comparator 29 which is connected to the selection regulation control means 27, and a gain of the variable gain amplifying unit 22 is varied, whereby the output voltage V3 of the detector signal processing circuit 8 can be totally agreed, to a required voltage level, with high accuracy.

Therefore, a width of a gain of the detector signal processing circuit 8 can be automatically varied, by the selection regulation control means 27 in which the comparator 29 is added, with a larger and higher accuracy width in comparison with a conventional device. Therefore, as a result, a width of a current of the neutron detector 3, which can be measured, can be extended.

### Embodiment 3

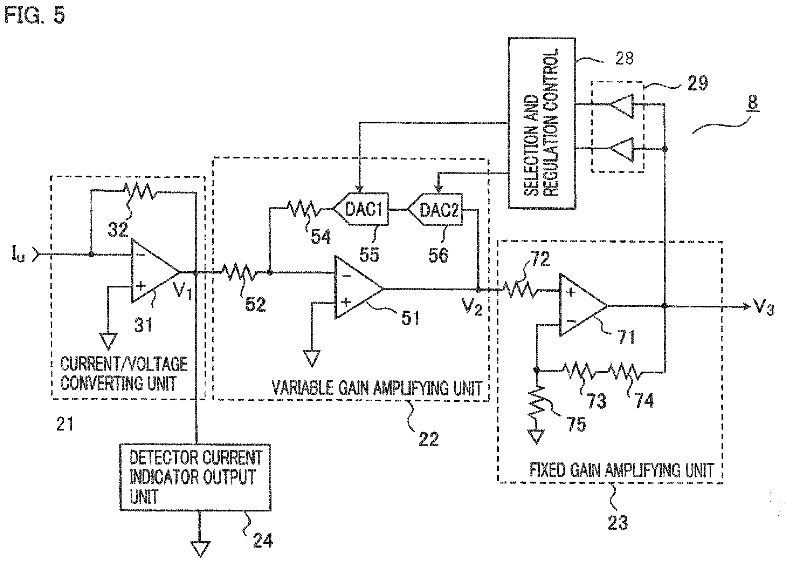

FIG. 5 is a circuit configuration diagram illustrating a detector signal processing circuit (I/E amplifier) 8 according to Embodiment 3, and two D/A converter 55 (DAC1) and D/A converter 56 (DAC2) are connected in series in such a way that the D/A converters of a variable gain amplifying unit 22 are connected as a two-stage configuration with respect to FIG. 1.

The unilateral D/A converter 55 corresponds to the current-level-responsible resistor circuit 61 according to Embodiment 1, and a resistance value is largely selected by a selection regulation control means 28 based on a comparator 29, and the other D/A converter 56 corresponds to the D/A converter 53 according to Embodiment 1, and a resistance value is mutely regulated by the selection regulation control means 28 based on the comparator 29.

Therefore, a width of a gain of the variable gain amplifying unit 22, in other words, a width of a gain of the detector signal processing circuit 8 can be automatically varied, in accordance with a control operation and a selection regulation control operation by the comparator 29, with a greater and higher accuracy width in comparison with a conventional device. Therefore, as a result, a width of a current of the neutron detector 3, which can be measured, can be extended.

In the above-described Embodiment 1 through Embodiment 3, although the output voltage V3 of the fixed gain amplifying unit 23 is input to the comparator 29 in a selection and regulation operation of a gain, the present invention is not limited to the operation, and it is needless to say that the output voltage V2 of the variable gain amplifying unit 22 is directly connected to the comparator 29, and a count value is commanded and controlled by the selection regulation control means 28.

### Description of the Symbols

- 1: ex-core nuclear instrumentation board
- 3: neutron detector
- 8: detector signal processing circuit
- 14: ex-core nuclear instrumentation device
- 16: nuclear reactor vessel
- 21: current/voltage converting unit
- 22: variable gain amplifying unit
- 23: fixed gain amplifying unit
- 24: detector current indicator output unit
- 25: regulation control means
- 26, 27, 28: selection regulation control means
- 29: comparator
- 41: current-level-responsible resistor circuit
- 42 to 44: resistors
- 45 to 47: analog switches
- 53, 55, 56: D/A converters
- 61: a current-level-responsible resistor circuit
- 62 to 64: resistors
- 65 to 67: analog switches.

## Claims

1. An ex-core nuclear instrumentation device comprising:
- a neutron detector which is adapted to measure a neutron beam at the outside of a nuclear reactor vessel and to convert the neutron beam to a current value; and
- an ex-core nuclear instrumentation board which is adapted to compute and process the current value from the neutron detector by using a detector signal processing circuit so as to output a state of the neutron beam when a nuclear reactor is operated;
wherein the detector signal processing circuit comprises:
- a current/voltage converting unit which is adapted to convert the current value converted by the neutron detector to a voltage value corresponding to the current value;
- a variable gain amplifying unit which includes an operating amplifier, in which a D/A converter is added, and is adapted to amplify the voltage value converted by the current/voltage converting unit;
- a regulation controller which is adapted to regulate a gain of the D/A converter; and
- a comparator which is adapted to compare an output voltage amplified by the variable gain amplifying unit with a reference value previously set, and to output its output voltage to the regulation controller.

2. The ex-core nuclear instrumentation device according to claim 1,
wherein the detector signal processing circuit comprises :
- the current/voltage converting unit which is adapted to convert the current value converted by the neutron detector to a voltage value corresponding to the current value;
- a detector current indicator output unit which is adapted to indicate the current value converted by the neutron detector from the voltage value converted by the current/voltage converting unit;
- the variable gain amplifying unit which includes an operating amplifier, in which a current-level-responsible resistor circuit for selecting a gain, and a D/A converter for regulating the gain, are included, and which is adapted to amplify the voltage value converted by the current/voltage converting unit; and
- the comparator which is connected to a selection regulation controller, which is adapted to select the gain of the current-level-responsible resistor circuit for regulating the gain of the D/A converter, and to automatically compare the voltage value obtained from the variable gain amplifying unit with a reference value previously set.

3. The ex-core nuclear instrumentation device according to claim 1,
wherein the detector signal processing circuit comprises:
- the current/voltage converting unit which includes the operating amplifier having a current-level-responsible resistor circuit, for selecting a gain, and is adapted to amplify and convert the current value converted by the neutron detector to a voltage value corresponding to the current value;
- a detector current indicator output unit which is adapted to indicate the current value converted by the neutron detector from the voltage value amplified and converted by the current/voltage converting unit;
- the variable gain amplifying unit which includes the operating amplifier having the D/A converter for regulating the gain, and which is adapted to amplify the voltage value amplified and computed by the current/voltage converting unit; and
- the comparator which is connected to a selection regulation controller, which is adapted to select the gain of the current-level-responsible resistor circuit and regulates the gain of the D/A converter, and to automatically compare the voltage value obtained from the variable gain amplifying unit with a reference value previously set.

4. The ex-core nuclear instrumentation device according to claim 2 or 3,
wherein the current-level-responsible resistor circuit is composed of a plurality of serial components which include resistors and analog switches.

5. The ex-core nuclear instrumentation device according to claim 1,
wherein the detector signal processing circuit comprises:
- the current/voltage converting unit which is adapted to convert the current value converted by the neutron detector to a voltage value corresponding to the current value;
- a detector current indicator output unit which is adapted to indicate the current value converted by the neutron detector from the voltage value converted by the current/voltage converting unit;
- the variable gain amplifying unit having two D/A converters, which are connected in series, and an operating amplifier which is adapted to select a gain in accordance with a current value level converted by the neutron detector, by one of the D/A converters, and to regulate a gain by the other D/A converter, and which is adapted to amplify the voltage value converted by the current/voltage converting unit; and
- the comparator which is connected to a selection regulation controller, which is adapted to select and regulate the gains of the two D/A converters, and to automatically compare the voltage value obtained from the variable gain amplifying unit with a reference value previously set.

6. The ex-core nuclear instrumentation device
according to any one of claims 1 to 3 and claim 5,
wherein the comparator is adapted to be automatically regulated in such a way that a predetermined target value is realized and is set within a span between an upper limit reference value and a lower limit reference value by previously setting the upper limit reference value and the lower limit reference value as predetermined values.
